# EUROPEAN PATENT SPECIFICATION

(11) **EP 2 565 536 B1**
(45) Date of publication and mention of the grant of the patent: **03.05.2017**
(21) Application number: 11774740.2
(22) Date of filing: 28.03.2011
(51) Int. Cl.: F21S 4/20, F21V 3/02, F21V 21/02, F21Y 101/00, H01L 33/64, F21Y 103/10, F21W 131/305, F21W 131/405, F21Y 115/10

(54) **LIGHT EMITTING DEVICE, AND STRUCTURE FOR ATTACHING LIGHT EMITTING DEVICE**
LICHTEMITTIERENDE VORRICHTUNG SOWIE STRUKTUR ZUR BEFESTIGUNG DER LICHTEMITTIERENDEN VORRICHTUNG
DISPOSITIF ÉMETTEUR DE LUMIÈRE, ET STRUCTURE DE FIXATION POUR DISPOSITIF ÉMETTEUR DE LUMIÈRE

(30) Priority: 28.04.2010 JP 2010103718
(43) Date of publication of application: 06.03.2013
(73) Proprietor: Patlite Corporation, Osaka-shi, Osaka 541-0056 (JP)
(72) Inventor: MIYATAKE, Tetsuya, Osaka-shi Osaka 542-0067 (JP); HAZUMI, Koichi, Osaka-shi Osaka 542-0067 (JP)
(74) Representative: Witte, Weller & Partner Patentanwälte mbB
(86) International application number: PCT/JP2011/057698
(87) International publication number: WO 2011/135956

(56) References cited:
- EP-A1- 2 650 595
- JP-A- 6 168 616
- JP-A- 2009 054 405
- JP-A- 2009 199 820
- JP-A- 2010 040 494
- US-A1- 2003 103 347
- US-A1- 2009 219 713

## Description

### TECHNICAL FIELD

The present invention relates to a light emitting apparatus, and to a light emitting apparatus mount structure.

### BACKGROUND ART

Light emitting apparatuses are known, which include light emitting elements such as LEDs (Light Emitting Diodes) (see, for example, PLT1). An LED lamp disclosed in PLT1 includes a plurality of LEDs supported by an aluminum support plate. A transparent tube having a generally semicircular cross section is attached to the support plate, and.the LEDs are disposed in the tube. Laterally opposite edge portions of the tube are each folded back inward of the tube into a claw shape. These claw-shaped portions are respectively fitted in grooves formed in the support plate as each having an L-shaped cross section. Thus, the tube is connected to the support plate

From document US 2009/0210713 A1 an LED lighting unit with an elongated heat sink is known, wherein the heat sink has two spaced apart longitudinal grooves, wherein the grooves are facing tangentially and wherein at least one LED is mounted to the heat sink between the grooves. The at least one LED is enclosed by a cover having bulged longitudinal edges by sliding the bulged longitudinal edges into the grooves.

From US 2003/0103347 A1 an illumination system is known comprising at least one mounting strip and one or more emitter strips each having an outwardly directed face in use through which infrared light may be transmitted. The system comprises further one or more printed circuit boards each carrying a plurality of infrared light emitting diodes and one or more contact elements. In the disclosed system, each emitter strip can interconnect with a mounting strip to form a conduit through which a power supply bus may be carried and each contact element is adapted to complete an electrical connection between the power supply bus and printed circuit board mounted behind the outwardly directed face of the emitter strip.

### CITATION LIST

### PATENT LITERATURE

PLT1: JP2009-199820A (Paragraphs [0023] to [0025])

### SUMMARY OF INVENTION

### TECHNICAL PROBLEM

In an arrangement disclosed in PLT1, the claw-shaped portions which are formed by folding the laterally opposite edge portions of the tube into the claw shape cannot have a great thickness. Therefore, the tube and the support plate are connected to each other with a limited connection strength. This results in limitations in improving the strength of an enclosure of the light emitting apparatus.

The LEDs have higher light directivity. Therefore, if the support plate is bent by thermal expansion (thermal elongation) thereof to change the orientations of the LEDs, a light illumination state is changed to an extent such that people feel uncomfortable. Therefore, the support plate is required to be free from the bending which may otherwise occur due to the thermal elongation.

### SOLUTION TO PROBLEM

It is an object of the present invention to provide a light emitting apparatus which has a higher strength and is arranged to substantially prevent a light emitting element support member thereof from being bent at a higher temperature, and to provide a light emitting apparatus mount structure.

According to a preferred embodiment of the present invention to achieve the object descried above, there is provided a light emitting apparatus, which includes: a light-transmissive cover including a pair of side walls; a heat dissipation member including a pair of outer surfaces disposed between inner surfaces of the pair of side walls of the cover and including a fin disposed between the outer surfaces; and a light emitting element supported by the heat dissipation member and accommodated in the cover; one of the cover and the heat dissipation member having projections respectively provided on the inner surfaces of the cover or the outer surfaces of the heat dissipation member; the other of the cover and the heat dissipation member having recesses respectively provided on the inner surfaces of the cover or the outer surfaces of the heat dissipation member, the recesses extending longitudinally of the cover in engagement with the respective projections.

With this arrangement, the pair of outer surfaces of the heat dissipation member receive the pair of side wall inner surfaces of the cover. Thus, the heat dissipation member serves as a reinforcement member which reinforces the pair of side walls of the cover. This enhances the strength of the pair of side walls, which serve as an enclosure of the light emitting apparatus. The heat dissipation member is connected to the pair of side walls by the engagement between the recesses and the projections. This eliminates the need for providing fragile members such as claws on the pair of side walls for the connection between the pair of side walls and the heat dissipation member, thereby enhancing the strength of the enclosure of the light emitting apparatus. Further, the pair of side walls are disposed outward of the heat dissipation member to hold the heat dissipation member therebetween and, therefore, have no limitation in thickness. This makes it possible to determine the thickness of the cover so that the pair of side walls of the cover each have sufficiently high strength.

The cover and the heat dissipation member are connected to each other by the engagement between the recesses each extending longitudinally of the cover and the projections. Therefore, if the heat dissipation member is thermally elongated (thermally expanded) longitudinally of the cover, the elongation of the heat dissipation member can be guided linearly longitudinally of the cover. This substantially prevents the heat dissipation member supporting the light emitting element from being bent (or warped), so that the light emitting element is substantially free from the change in orientation. This suppresses the change in light view, thereby suppressing the change in light illumination state which may otherwise cause people to feel uncomfortable. Particularly, where an LED having higher light directivity is used as the light emitting element, the change in light illumination state can be highly effectively suppressed which may otherwise cause people to feel uncomfortable.

The cover has a hollow tubular shape to surround the heat dissipation member.

With this arrangement, the fin is covered with the cover, thereby suppressing adhesion of dust to the fin which has a large surface area. Thus, the light emitting apparatus can be kept clean for a longer period of time. The light emitting apparatus arranged in this manner is advantageous as a lighting device for illuminating foodstuff in a food section. Where the fin is merely required to reduce an ambient temperature around the light emitting element in the light emitting apparatus, there is no problem associated with the heat dissipation even with the fin covered with the cover.
Particularly where the LED is used as the light emitting element, the light emitting apparatus may be designed according to the heat dissipation amount of the LED and the heat resistance of the cover. Therefore, even if the fin is covered with the cover, the heat dissipation problem is not serious.

The heat dissipation member preferably includes a base which supports the light emitting element, and the light emitting element is preferably disposed on a side of the base opposite from the fin.

With this arrangement, light emitted from the light emitting element is substantially prevented from being blocked by the fin. Thus, the light emitting apparatus can illuminate a larger area.

The recesses and the projections preferably each have a smoothly curved surface.

With this arrangement, the member formed with the recesses or the member formed with the projections (the cover or the heat dissipation member) has a higher dimensional accuracy when it is produced by molding. The surfaces of the recesses and the projections are smoothly curved. Therefore, a melted synthetic resin can be spread over a cavity surface of a mold with no void, whereby the member described above (the cover or the heat dissipation member) can be molded in accurate conformity with the shape of a cavity of the mold. Consider, for example, that the recesses and the projections each have an angular portion (sharp edge). In this case, when the melted synthetic resin is fed into the cavity of the mold in the molding of the member, it is difficult to fully spread the synthetic resin over an angular cavity surface of the mold. This may result in difficulty in molding the member in accurate conformity with the shape of the cavity of the mold.

The recesses and the projections preferably each extend longitudinally throughout the entire length of the corresponding one of the cover and the heat dissipation member.

With this arrangement, the projections are connected to the recesses with a higher connection strength.

An inventive light emitting apparatus mount structure preferably includes the light emitting apparatus described above and a bracket to be fixed to a fixing surface, wherein the bracket includes a pair of clamp pieces which hold the pair of side walls of the cover therebetween to hold the recesses and the projections therebetween.

With this arrangement, the cover is held between the pair of clamp pieces of the bracket to be thereby retained by the bracket. Thus, the light emitting apparatus can be attached to the bracket simply by inserting the cover between the pair of clamp pieces. Further, the light emitting apparatus can be detached from the bracket simply by taking out the cover from between the pair of clamp pieces. Therefore, the light emitting apparatus can be easily attached to and detached from the bracket. The pair of clamp pieces of the bracket hold the recesses and the projections therebetween. Thus, the connection strength between contact portions of the cover and the heat dissipation member can be enhanced by the positional relationship between the contact portions of the cover and the heat dissipation member and the rigidity of the heat dissipation member. The pair of side walls of the cover, which have a connection strength enhanced by the engagement between the recesses and the projections can be held between the pair of clamp pieces. This suppresses unwanted deformation of the cover when the cover is held between the pair of clamp pieces.

The outer surfaces of the cover are preferably conformable to the inner surfaces of the cover as seen longitudinally of the cover.

With this arrangement, the cover has a generally uniform wall thickness. Therefore, the cover can be produced at improved productivity. Particularly, where the cover is produced by extrusion, the productivity can be improved.

Opposed inner surfaces of the pair of clamp pieces are preferably curved to be fitted on the outer surfaces of the cover.

With this arrangement, the inner surfaces of the respective clamp pieces are smoothly curved. This substantially prevents the cover from being damaged when the light emitting apparatus is attached to or detached from the bracket.

### BRIEF DESCRIPTION OF DRAWINGS

FIG. 1 is a perspective view schematically illustrating a light emitting apparatus mount structure according to one embodiment of the present invention.
FIG. 2 is an exploded perspective view of a light emitting apparatus and a perspective view of brackets.
FIG. 3 is a sectional view illustrating the light emitting apparatus and the bracket in a separate state in section perpendicular to the length of the light emitting apparatus.
FIG. 4 is a sectional view illustrating the light emitting apparatus fixed to the bracket as seen from a lateral side.
FIG. 5 is a partial enlarged view of FIG. 4.
FIGS. 6A, 6B, 6C and 6D are major sectional views for explaining how to attach and detach the light emitting apparatus to/from the bracket.
FIG. 7 is a sectional view of the light emitting apparatus fixed to the bracket.
FIG. 8 is a perspective view of a bracket according to another embodiment of the present invention.
FIG. 9 is a major sectional view according to further another embodiment of the present invention.

### EMBODIMENTS OF THE INVENTION

Embodiments of the present invention will hereinafter be described specifically with reference to the drawings.

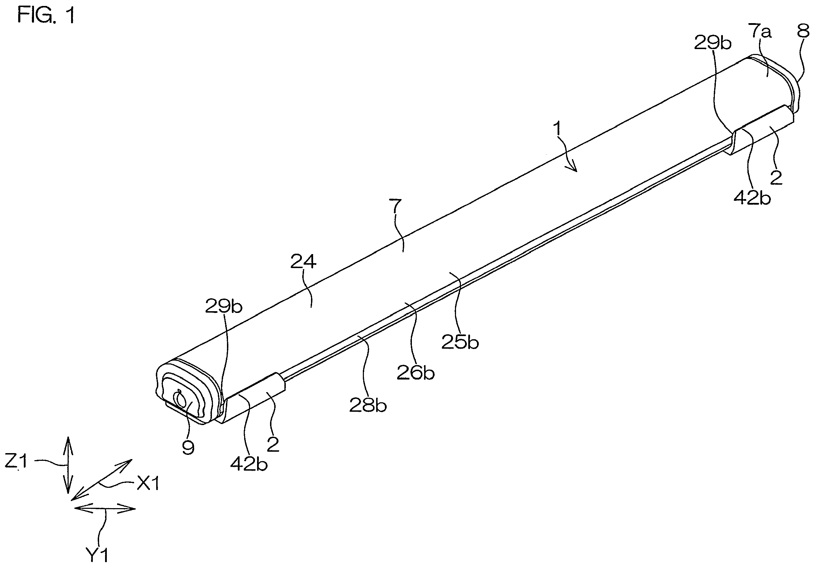

FIG. 1 is a perspective view schematically illustrating a light emitting apparatus mount structure according to one embodiment of the present invention. Referring to FIG. 1, a light emitting apparatus 1 is, for example, a lighting device to be mounted on a wall of a structure such as a house. The present invention is applicable not only to the lighting device but also to indication devices such as road signs, light emitting apparatuses to be fixed to a structure, portable light emitting apparatuses, and other light emitting apparatuses. This embodiment is directed to the lighting device by way of example.

The light emitting apparatus 1 is adapted to be fixed to a wall (not shown) defined as the fixing surface via two brackets 2. The light emitting apparatus 1 and the brackets 2 collectively define the light emitting apparatus mount structure.

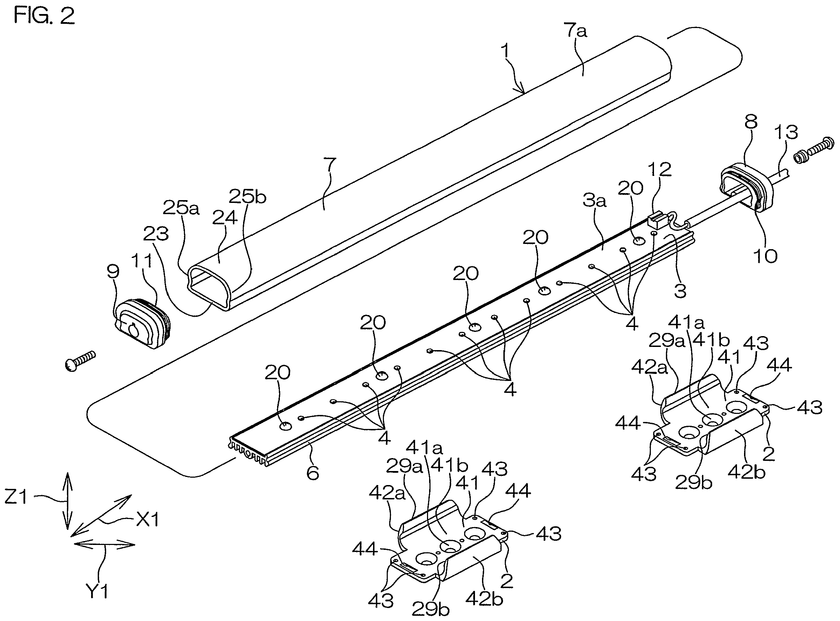

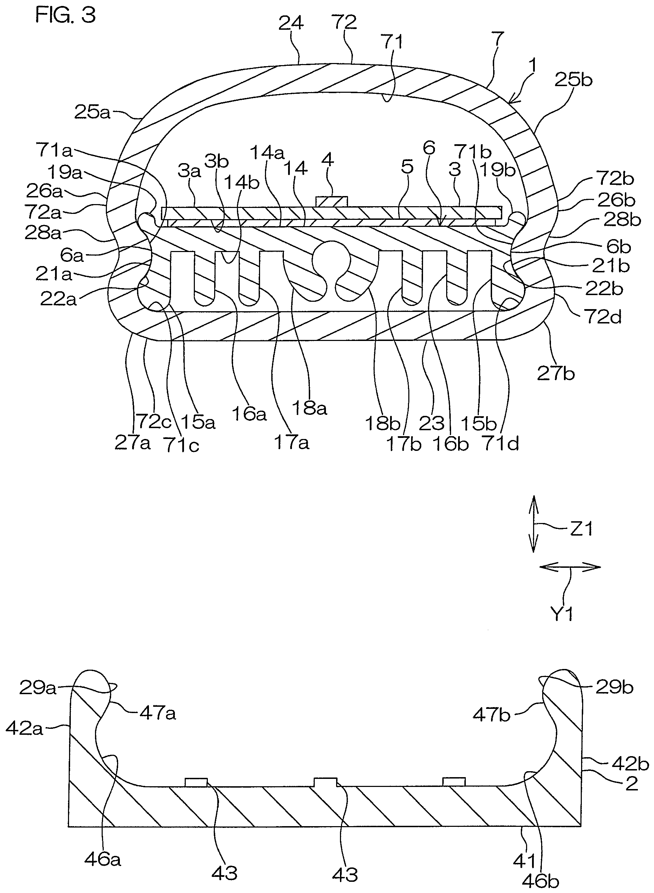

FIG. 2 is an exploded perspective view of the light emitting apparatus 1 and a perspective view of the brackets 2. FIG. 3 is a sectional view illustrating the light emitting apparatus 1 and the bracket 2 in a separate state in section perpendicular to the length of the light emitting apparatus 1. As shown in FIGS. 2 and 3, the light emitting apparatus 1 includes a circuit board 3, LEDs (Light Emitting Diodes) 4 defined as the light emitting element, a sheet 5, a heat dissipation member 6, a cover 7, caps 8, 9 and seal members 10, 11.

The circuit board 3 is provided as a base member which supplies electric power to the LEDs 4 and supports the LEDs 4. The circuit board 3 is configured in a rectangular plate shape extending longitudinally (X1) of the cover 7. A connector 12 is fixed to a front surface 3a of the circuit board 3. The connector 12 is electrically connected to a power source (not shown) provided outside the light emitting apparatus 1 via a power supply cord 13.

The connector 12 is electrically connected to the LEDs 4 via an electrically conductive pattern (not shown) formed in the circuit board 3.

The LEDs 4 are adapted to emit light by the supply of the electric power from the power source. The LEDs 4 are generally rectangular members each having an edge length of several millimeters and a thickness of about 1 mm. The LEDs 4 are arranged generally equidistantly longitudinally (X1) of the cover 7. The LEDs 4 are disposed on the circuit board 3 at generally middle positions defined transversely (Y1) of the cover 7 (in a direction perpendicular to the longitudinal direction X1 and parallel to the front surface 3a of the circuit board 3).

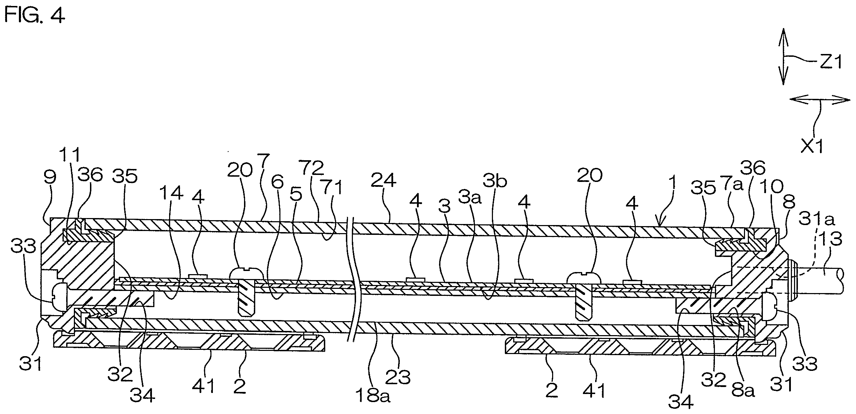

FIG. 4 is a sectional view illustrating the light emitting apparatus 1 fixed to the brackets 2 as seen from a lateral side. Referring to FIGS. 3 and 4, the sheet 5 serves to dissipate heat generated from the LEDs 4 by light emission from the LEDs 4. The sheet 5 is fixed to a back surface 3b of the circuit board 3, for example, by bonding. In this embodiment, the sheet-form heat dissipation material is used by way of example but, instead, a grease-form heat dissipation material may be used.

The heat dissipation member 6 serves to dissipate heat conducted from the LEDs 4 via the circuit board 3 and the sheet 5. The heat dissipation member 6 also serves to support the circuit board 3. The heat dissipation member 6 is formed, for example, of a material such as an aluminum alloy having excellent thermal conductivity. The heat dissipation member 6 is configured uniformly along the longitudinal direction X1. The heat dissipation member 6 is configured symmetrically along the transverse direction Y1 (lateral direction).

The heat dissipation member 6 includes a base 14, a pair of first fins 15a, 15b, a pair of second fins 16a, 16b, a pair of third fins 17a, 17b, and a pair of fourth fins 18a, 18b.

The base 14 is configured in a rectangular plate shape. The base 14 has a flat front surface 14a to which a back surface of the sheet 5 is fixed, for example, by bonding. That is, the circuit board 3 is attached to the front surface 14a of the base 14 via the sheet 5. The base 14 has projections 19a, 19b respectively provided on transversely (Y1) opposite edges of the front surface 14a thereof. The height level of the projections 19a, 19b (as measured from the front surface 14a of the base 14) is lower than the height level of the front surface 3a of the circuit board 3 from the front surface 14a of the base 14. Thus, the projections 19a, 19b do not block light emitted from the LEDs 4.

Through-holes each extend through the base 14, the sheet 5 and the circuit board 3, and fixture screws 20 are attached to the through-holes. Thus, the circuit board 3 is fixed to the heat dissipation member 6.

The pairs of fins 15a, 15b; 16a, 16b; 17a, 17b; 18a, 18b are connected to a back surface 14b of the base 14. That is, the pairs of fins 15a, 15b; 16a, 16b; 17a, 17b; 18a, 18b are disposed on a side of the base 14 opposite from the LEDs 4.

The pair of first fins 15a, 15b are disposed on transversely (Y1) opposite edges of the heat dissipation member 6. The first fins 15a, 15b each extend from the back surface 14b of the base 14 in a height direction Z1 of the cover 7 (perpendicular to the longitudinal direction X1 and the transverse direction Y1). One 15a of the first fins, a part of the base 14 and one 19a of the projections collectively define an outer surface 6a of the heat dissipation member 6. Similarly, the other first fin 15b, a part of the base 14 and the other projection 19b collectively define an outer surface 6b of the heat dissipation member 6. That is, the heat dissipation member 6 has a pair of outer surfaces 6a, 6b thus defined. The pairs of fins 15a, 15b; 16a, 16b; 17a, 17b; 18a, 18b are disposed between the pair of outer surfaces 6a, 6b.

The outer surfaces 6a, 6b respectively have first recesses 21a, 21b. The first recesses 21a, 21b extend longitudinally (X1) throughout the entire length of the heat dissipation member 6. The first recesses 21a, 21b each have a smoothly curved surface which is arcuate as seen longitudinally (X1). As seen longitudinally (X1), the curvature radius of the first recess 21a is generally constant, and the curvature radius of the first recess 21b is also generally constant.

The pair of second fins 16a, 16b are disposed between the pair of first fins 15a, 15b. The second fins 16a, 16b each have a smaller depth than the first fins 15a, 15b (as measured from the back surface 14b of the base 14).

The pair of third fins 17a, 17b are disposed between the pair of second fins 16a, 16b. The third fins 17a, 17b each have substantially the same depth as the second fins 16a, 16b.

The pair of fourth fins 18a, 18b are disposed between the pair of third fins 17a, 17b. Opposed surfaces of the fourth fins 18b, 18b and a part of the back surface 14b of the base 14 present between these opposed surfaces are collectively configured into an arcuate shape as seen longitudinally.

The cover 7 is, for example, a hollow tubular member formed from a synthetic resin such as a polycarbonate by extrusion, and is configured uniformly along the longitudinal direction X1. The cover 7 accommodates and surrounds the circuit board 3, the LEDs 4, the sheet 5 and the heat dissipation member 6. The cover 7 is a transparent or translucent member, which is light-transmissive or capable of transmitting light. Therefore, the light emitted from the LEDs 4 passes thorough the cover 7 to illuminate an ambient space outside the cover 7.

The cover 7 has a wall thickness which is generally constant throughout the entire periphery of the cover 7. Therefore, an inner surface 71 and an outer surface 72 of the cover 7 are conformable to each other as seen longitudinally (X1). The cover 7 is configured symmetrically transversely (Y1).

The cover 7 includes a bottom wall 23, a top wall 24 and a pair of side walls 25a, 25b.

The bottom wall 23 is configured in a generally planar shape. The bottom wall 23 is disposed generally parallel to the base 14 of the heat dissipation member 6. The bottom wall 23 is disposed with respect to the pairs of fins 15a, 15b; 16a, 16b; 17a, 17b; 18a, 18b in the height direction Z1.

The top wall 24 is opposed to and spaced a predetermined distance from the LEDs 4 in the height direction Z1. The top wall 24 is smoothly convexly curved away from the circuit board 3 as seen longitudinally (X1).

The pair of side walls 25a, 25b connect the bottom wall 23 to the top wall 24. The pair of side walls 25a, 25b project from the bottom wall 23 toward the top wall 24. First portions 26a, 26b of the pair of the side walls 25a, 25b adjacent to the bottom wall 23 extend along the pair of outer surfaces 6a, 6b of the heat dissipation member 6. Thus, the first portions 26a, 26b are convexly curved toward the heat dissipation member 6 as seen longitudinally (X1).

The pair of outer surfaces 6a, 6b of the heat dissipation member 6 are held between inner surfaces 71a, 71b of the pair of the side walls 25a, 25b of the cover 7. The inner surfaces 71a, 71b respectively include first projections 22a, 22b. The first projections 22a, 22b extend longitudinally (X1) throughout the entire length of the cover 7. The pair of first projections 22a, 22b are configured to be generally complementary in shape to the pair of first recesses 21a, 21b. That is, the first projections 22a, 22b each have a smoothly curved surface which is arcuate as seen longitudinally (X1). As seen longitudinally (X1), the curvature radius of the first projection 22a is generally constant, and the curvature radius of the first projection 22b is also generally constant.

The first projections 22a, 22b are respectively engaged with the corresponding recesses 21a, 21b, and slidable longitudinally (X1) with respect to the corresponding first recesses 21a, 21b. The first projections 22a, 22b are respectively fitted in the corresponding first recesses 21a, 21b, and kept in surface contact with the corresponding first recesses 21a, 21b.

The cover 7 includes connection portions 27a, 27b, which connect the pair of side walls 25a, 25b to the bottom wall 23. The connection portions 27a, 27b of the cover 7 respectively have smoothly curved inner surfaces 71c, 71d, which respectively extend along the pair of first fins 15a, 15b. Thus, the inner surfaces 71c, 71d of the connection portions 27a, 27b of the cover 7 are kept in surface contact with the pair of first fins 15a, 15b.

Outer surfaces 72a, 72b of the pair of side walls 25a, 25b of the cover 7 respectively include second recesses 28a, 28b. The second recesses 28a, 28b extend longitudinally (X1) throughout the entire length of the cover 7. The pair of second recesses 28a, 28b are configured in substantially the same shapes as the pair of first recesses 21a, 21b. That is, the second recesses 28a, 28b each have a smoothly curved surface, which is arcuate as seen longitudinally (X1).

As seen longitudinally (X1), the curvature radius of the second recess 28a is generally constant, and the curvature radius of the second recess 28b is also generally constant. The pair of first recesses 21a, 21b, the pair of first projections 22a, 22b and the pair of second recesses 28a, 28b are juxtaposed transversely (Y1).

Referring to FIGS. 2 and 4, the cap 8 closes one end 7a of the cover 7. The cap 8 includes a cap body 31, and a projection 32 projecting from the cap body 31 toward the cover 7.

The cap body 31 covers the end 7a of the cover 7. An outer periphery of the cap body 31 is opposed to the end 7a of the cover 7. The outer periphery of the cap body 31 is spaced longitudinally (X1) from the end 7a of the cover 7. The cap body 31 has an insertion hole 31a. The power supply cord 13 extends from the inside to the outside of the cover 7 through the insertion hole 31a.

At least a part of the projection 32 is located inside the cover 7. An outer peripheral surface of the projection 32 has a smoothly curved shape which is generally conformable to the inner surface 71 of the cover 7, and is spaced from the inner surface 71 of the cover 7.

A screw insertion hole 8a extends through the cap body 31 and the projection 32. A fixture screw 33 is inserted through the screw insertion hole 8a. The fixture screw 33 is threadingly connected to a screw hole 34 provided in the heat dissipation member 6. Thus, the cap 8 is connected to the heat dissipation member 6. An O-ring (not shown) for water tightness and oil tightness is provided between the fixture screw 33 and the screw hole 34.

The seal member 10 serves to liquid-tightly seal a gap between the cover 7 and the cap 8. The seal member 10 is a unitary member molded from an elastic material such as a rubber. The seal member 10 includes a seal body 35 and a flange 36 projecting from the seal body 35.

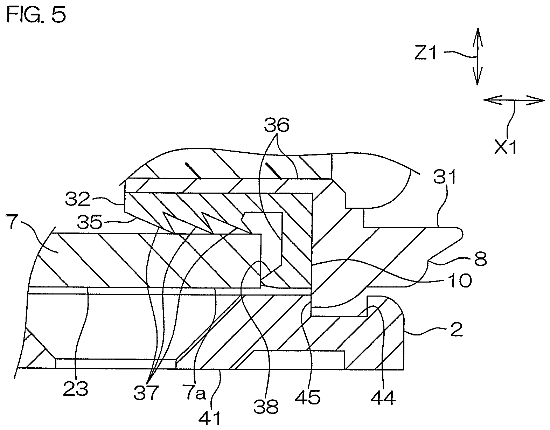

The seal body 35 is disposed between the outer peripheral surface of the projection 32 of the cap 8 and the inner surface 71 of the cover 7, and has a smooth annular shape with no angled portion. As shown in FIG. 5, which is a partially enlarged diagram of FIG. 4, a plurality of lips 37 are provided on an outer periphery of the seal body 35. The lips 37 are arranged longitudinally (X1). The lips 37 each extend throughout the entire periphery of the seal body 35, and are kept in contact with the inner surface 71 of the cover 7.

The flange 36 is disposed between the outer periphery of the cap body 31 and the end 7a of the cover 7. The flange 36 has a lip 38. The lip 38 extend throughout the entire periphery of the flange 36, and is kept in contact with the end 7a of the cover 7.

With the flange 36 disposed between the outer periphery of the cap body 31 and the end 7a of the cover 7, the cover 7 can be elongated longitudinally (X1) while compressing the flange 36 in thermal expansion thereof.

Referring to FIG. 4, the cap 9 has substantially the same structure as the cap 8, except that the cap 9 does not have the hole through which the power supply cord 13 is inserted. The seal member 11 has the same structure as the seal member 10. Therefore, detailed description of the cap 9 and the seal member 11 will be omitted.

The light emitting apparatus 1 is completed by inserting the heat dissipation member 6 provided with the LEDs 4, the circuit board 3, the sheet 5 and the like into the cover 7 longitudinally (X1) and then attaching the seal members 10, 11 and the caps 8, 9 to the cover 7. Thus, a simple method such that the heat dissipation member 6 is inserted into the cover 7 is employed for assembling the light emitting apparatus 1.

While the general construction of the light emitting apparatus 1 has thus been described, the brackets 2 will next be described.

As shown in FIG. 2, the brackets 2 are disposed, for example, at opposite ends of the light emitting apparatus 1 with respect to the longitudinal direction (X1) to support the light emitting apparatus 1 at two positions. The brackets 2 are identical in structure. Therefore, one of the brackets 2 which is disposed at the end 7a of the cover 7 will hereinafter be described.

The bracket 2 is a product molded from a synthetic resin such as a polycarbonate. The bracket 2 is, for example, transparent. The bracket 2 includes a base plate 41 and a pair of clamp pieces 42a, 42b. The base plate 41 is configured in a generally rectangular plate shape. The base plate 41 has a plurality of screw insertion holes 41a aligned longitudinally (X1). The base plate 41 is fixed to the wall by fixture screws (not shown) inserted through the screw insertion holes 41a.

The base plate 41 has projections 43 and stoppers 44 provided on a front surface 41b thereof. The projections 43 serve to press the bottom wall 23 of the cover 7 held between the pair of clamp pieces 42a, 42b. The cover 7 is pressed against the pair of clamp pieces 42a, 42b with the bottom wall 23 thereof being pressed by the projections 43. This substantially prevents the cover 7 from moving relative to the bracket 2 (or rattling).

The stoppers 44 are recessed from the front surface 41b of the base plate 41. The stoppers 44 include, for example, two stoppers 44 which are spaced from each other longitudinally (X1). As shown in FIG. 5, one of the stoppers 44 contacts a projection 45 provided on the outer periphery of the cap body 31. The projection 45 is disposed longitudinally (X1) outward of the stopper 44. Thus, the stopper 44 prevents the light emitting apparatus 1 from being displaced longitudinally (X1) with respect to the bracket 2 but permits free thermal elongation of the light emitting apparatus 1.

Referring to FIG. 3, the pair of clamp pieces 42a, 42b of the bracket 2 serve to hold the cover 7 and the heat dissipation member 6 of the light emitting apparatus 1 therebetween. The pair of clamp pieces 42a, 42b hold the first projections 22a, 22b and the first recesses 21a, 21b therebetween to hold the side walls 25a, 25b of the cover 7 therebetween. The pair of clamp pieces 42a, 42b extend from transversely (Y1) opposite edges of the base plate 41 in the height direction Y1. Distal edges of the pair of clamp pieces 42a, 42b are displaceable transversely (Y1). Opposed inner surfaces 46a, 46b of the pair of clamp pieces 42a, 42b are each smoothly curved, and have no sharp edge. The inner surfaces 46a, 46b of the pair of clamp pieces 42a, 42b conform in shape to the outer surfaces 72a, 72b of the pair of side walls 25a, 25b of the cover 7.

The clamp pieces 42a, 42b respectively include distal end portions 47a, 47b which are bulged so as to be spaced a smaller distance from each other. Thus, the pair of clamp pieces 42a, 42b have second projections 29a, 29b provided on inner surfaces 46a, 46b thereof. The second projections 29a, 29b each extend longitudinally (X1) throughout the entire length of the corresponding clamp piece 42a, 42b.

The pair of second projections 29a, 29b are configured in substantially the same shapes as the pair of first projections 22a, 22b as seen longitudinally (X1). That is, the second projections 29a, 29b each have a smoothly curved surface, which is arcuate as seen longitudinally (X1). As seen longitudinally (X1), the curvature radius of the second projection 29a is generally constant, and the curvature radius of the second projection 29b is also generally constant.

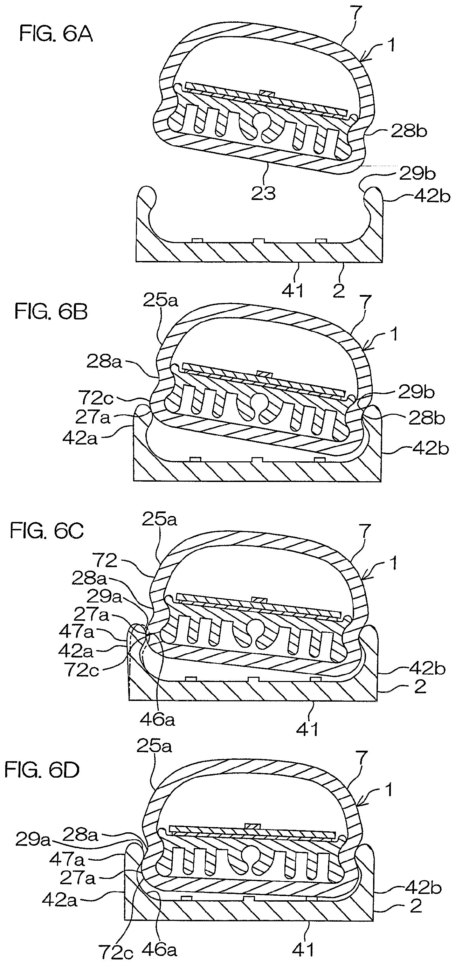

Next, how to attach and detach the light emitting apparatus 21 to/from the brackets 2 fixed to the wall will be described. When the light emitting apparatus 1 is to be attached to the brackets 2, as shown in FIG. 6A, the bottom wall 23 of the cover 7 of the light emitting apparatus 1 is tilted with respect to the base plates 41 of the brackets 2. In this state, as shown in FIG. 6B, the second recess 28a of the cover 7 is engaged with the second projections 29b of the brackets 2.

Then, the outer surface 72c of the connection portion 27a of the cover 7 is pressed against the clamp pieces 42a. Thus, as shown in FIG. 6C, the clamp pieces 42a are resiliently deformed by the outer surface 72c of the cover 7. The outer surface 72c of the connection portion 27a of the cover 7 and the inner surfaces 46a of the clamp pieces 42a are each smoothly curved. Therefore, the outer surface 72c and the inner surfaces 46a are substantially prevented from being damaged by the contact between the outer surface 72c and the inner surfaces 46a. Further, the clamp pieces 42a can be easily resiliently deformed so that the distal end portions thereof are moved away from the other clamp pieces 42b.

The cover 7 is pressed toward the base plate 41, whereby the second recess 28a of the cover 7 is engaged with the second projections 29a of the clamp pieces 42a as shown in FIG. 6D.

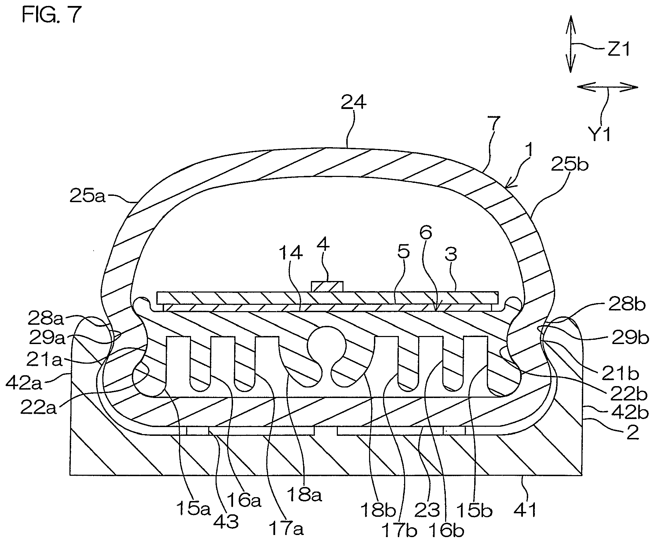

Then, as shown in FIG. 7, the light emitting apparatus 1 is fixed to the brackets 2 with the bottom wall 23 of the cover 7 being parallel to the base plate 41. The pair of second recesses 28a, 28b are resiliently held by the pairs of second projections 29a, 29b. The second recess 28a is slidable longitudinally (X1) relative to the second projections 29a. Similarly, the second recess 28b is slidable longitudinally (X1) relative to the second projections 29b.

The projections 22a, 22b; 29a, 29b and the recesses 21a, 21b; 28a, 28b are disposed on one side of the circuit board 3 (closer to the brackets 2) with respect to the height direction Z1. In contrast, the LEDs 4 are disposed on the other side of the circuit board 3 with respect to the height direction Z1. Thus, the projections 22a, 22b; 29a, 29b and the recesses 21a, 21b; 28a, 28b are separated from the LEDs 4 in the height direction Z1. Thus, the light emitted from the LEDs 4 toward the top wall 24 of the cover 7 is not blocked by the projections 22a, 22b; 29a, 29b and the recesses 21a, 21b; 28a, 28b.

In the light emitting apparatus 1, the LEDs 4 generate heat due to the lighting thereof. The heat generated by the LEDs 4 is conducted to the heat dissipation member 6 via the circuit board 3 and the sheet 5. The heat conducted to the heat dissipation member 6 is conducted from the base 14 to the fins 15a, 15b; 16a, 16b; 17a, 17b; 18a, 18b, and then released from a peripheral portion of the bottom wall 23 of the cover 7 to the outside of the light emitting apparatus 1.

When the light emitting apparatus 1 is to be detached from the brackets 2, as shown in FIG. 6D, the side wall 25a of the cover 7 is lifted from the brackets 2. At this time, the cover 7 and the clamp pieces 42a are prevented from being damaged, because the outer surface 72c of the connection portion 27a of the cover 7 and the inner surfaces 46a of the clamp pieces 42a are smoothly curved. In addition, the cover 7 is less liable to be caught by the clamp pieces 42a and, therefore, can be easily detached. With the side wall 25a of the cover 7 lifted, the clamp pieces 42a are resiliently deformed, so that the distal end portions of the clamp pieces 42a are moved away from the other clamp pieces 42b.

When the side wall 25a of the cover 7 is further lifted, the bulged portions 47a of the clamp pieces 42a are pressed by the connection portion 27a of the cover 7. Thus, the distances between the distal end portions of the pairs of clamp pieces 42a, 42b are further increased. Thus, as shown in FIG. 6C, the second recess 28a is moved over the second projections 29a. When the side wall 25a of the cover 7 is further lifted, the connection portion 27a of the cover 7 is slid with respect to the bulged portions 47a of the clamp pieces 42a away from the brackets 2. Thus, as shown in FIG. 6B, the side wall 25a of the cover 7 is disconnected from the clamp pieces 42a. Thereafter, the cover 7 is further lifted, whereby the light emitting apparatus 1 is detached from the brackets 2 as shown in FIG. 6A.

In this embodiment, as described above, the pair of first recesses 21a, 21b (outer surfaces) of the heat dissipation member 6 receive the pair of inner surfaces 71a, 71b of the side walls 25a, 25b of the cover 7. Thus, the heat dissipation member 6 serves as a reinforcement member which reinforces the pair of side walls 25a, 25b of the cover 7. This enhances the strength of the pair of side walls 25a, 25b serving as parts of the enclosure of the light emitting apparatus 1.

The pair of side walls 25a, 25b of the cover 7 are connected to the heat dissipation member 6 by the engagement between the first projections 22a, 22b and the first recesses 21a, 21b. Thus, there is no need to provide fragile members such as claws on the pair of side walls 25a, 25b for the connection between the side walls 25a, 25b and the heat dissipation member 6. This further enhances the strength of the enclosure of the light emitting apparatus 1. The pair of side walls 25a, 25b are disposed outward of the heat dissipation member 6 to hold the heat dissipation member 6 therebetween and, hence, have no limitation in thickness. Therefore, the thickness of the cover 7 can be determined so that the pair of side walls 25a, 25b have sufficiently high strength.

The cover 7 and the heat dissipation member 6 are connected to each other by the connection between the first projections 22a, 22b and the first recesses 21a, 21b extending longitudinally (X1). Therefore, if the heat dissipation member 6 is thermally elongated (thermally expanded) longitudinally (X1), the elongation of the heat dissipation member 6 can be linearly guided longitudinally (X1). This suppresses the bending (warpage) of the heat dissipation member 6 which supports the LEDs 4, so that the LEDs 4 are substantially free from the change in orientation. This suppresses the change in light view of the light emitting apparatus 1, thereby suppressing the change in light illumination state which may otherwise cause people to feel uncomfortable. Particularly, the LEDs 4 herein used are light emitting elements having higher light directivity and, therefore, the change in light illumination state can be highly effectively suppressed which may otherwise cause people to feel uncomfortable.

The fins 15a, 15b; 16a, 16b; 17a, 17b; 18a, 18b each having a greater surface area are covered with the cover and, therefore, are substantially free from adhesion of dust. Thus, the light emitting apparatus 1 is kept clean for a longer period of time. Therefore, the light emitting apparatus 1 is particularly advantageous as a lighting device for illuminating foodstuff in a food section. Since the fins 15a, 15b; 16a, 16b; 17a, 17b; 18a, 18b are merely required to reduce the ambient temperature around the LEDs 4, the light emitting apparatus 1 is free from the heat dissipation problem even with the fins 15a, 15b; 16a, 16b; 17a, 17b; 18a, 18b covered with the cover 7.

The fins 15a, 15b; 16a, 16b; 17a, 17b; 18a, 18b are disposed on the side of the base 14 opposite from the LEDs 4. This substantially prevents the light emitted from the LEDs 4 from being blocked by the fins 15a, 15b; 16a, 16b; 17a, 17b; 18a, 18b. Thus, the light emitting apparatus 1 can illuminate a larger area.

The inner surface 71 of the cover 7 and the outer peripheral surface of the projection 32 of the cap 8 are each smoothly curved. Since the inner surface 71 and the outer peripheral surface of the projection 32 opposed to each other are each smoothly curved, the gap between the inner surface 71 and the outer peripheral surface of the projection 32 can be easily sealed with the seal body 35 of the seal member 10. Therefore, where the seal member 10 is provided between the inner surface 71 and the outer peripheral surface of the projection 32 which are each smoothly curved, foreign matter is less liable to intrude into the gap between the inner surface 71 and the outer peripheral surface of the projection 32.

Consider, for example, that the inner surface of the cover and the outer peripheral surface of the projection each have an angular portion. In this case, the seal member cannot be easily kept in intimate contact with the angular portion, so that foreign matter is liable to intrude into the gap between the inner surface of the cover and the outer peripheral surface of the projection. In this embodiment, however, the inner surface 71 of the cover 7 and the inner peripheral surface of the projection 32 are each smoothly curved, so that the gap between these surfaces can be easily sealed.

Further, the dimensional accuracy of the cover 7 is increased when the cover 7 is molded from the resin. The first projections 22a, 22b each have a smoothly curved surface. Therefore, a melted synthetic resin can be spread over a cavity surface of a mold with no void, whereby the cover 7 can be molded in accurate conformity with the shape of the cavity of the mold.

Consider, for example, that the first projections each have an angular portion. In this case, when the melted synthetic resin is fed into the cavity of the mold in the molding of the cover, it is difficult to fully spread the synthetic resin over an angular cavity surface of the mold. This may result in difficulty in molding the cover in accurate conformity with the shape of the cavity of the mold.

The first recesses 21a, 21b and the first projections 22a, 22b respectively extend longitudinally (X1) throughout the entire lengths of the heat dissipation member 6 and the cover 7. Thus, the first recesses 21a, 21b are connected to the corresponding first projections 22a, 22b with a higher connection strength.

With the second recesses 28a, 28b of the cover 7 being held between the pairs of clamp pieces 42a, 42b of the brackets 2 with a minimum stress, the cover 7 is held by the brackets 2. Thus, the light emitting apparatus 1 can be attached to the brackets 2 simply by inserting the cover 7 between the pairs of clamp pieces 42a, 42b.

Further, the light emitting apparatus 1 can be detached from the brackets 2 simply by taking out the cover 7 from between the pairs of clamp pieces 42a, 42b. Therefore, the light emitting apparatus 1 can be easily attached to and detached from the brackets 2. Further, the first projections 22a, 22b and the first recesses 21a, 21b are held between the pairs of clamp pieces 42a, 42b of the brackets 2.

Thus, the connection strength between the cover 7 and the heat dissipation member 6 kept in contact with each other can be enhanced by the positional relationship between the contact portions of the cover 7 and the heat dissipation member 6 and the rigidity of the heat dissipation member 6. Further, the pair of side walls 25a, 25b, which have a connection strength enhanced by the engagement between the first projections 22a, 22b and the first recesses 21a, 21b, can be held between the pairs of clamp pieces 42a, 42b. This suppresses unwanted deformation of the cover 7 when the cover is held between the pairs of clamp pieces 42a, 42b.

The outer surface 72 and the inner surface 71 of the cover 7 are conformable to each other as seen longitudinally (X1). Thus, the cover 7 has a generally constant wall thickness. Therefore, the cover 7 can be produced at improved productivity. Particularly, where the cover 7 is produced by extrusion, the productivity can be improved.

Further, the inner surfaces 46a, 4 6b of the pairs of clamp pieces 42a, 42b are curved to be fitted on the outer surface 72 of the cover 7. With the inner surfaces 46a, 46b of the respective clamp pieces 42a, 42b thus smoothly curved, the cover 7 is substantially prevented from being damaged when the light emitting apparatus 1 is attached to or detached from the brackets 2.

When the light emitting apparatus 1 is thermally elongated, the brackets 2 permit free elongation of the cover 7 and the heat dissipation member 6. Thus, the caps 8, 9 and the seal members 10, 11 disposed on the opposite ends of the cover 7 are prevented from being subjected to a great force (flexural force). As a result, the reduction in the sealability of the seal members 10, 11 is suppressed.

The present invention is not limited to the embodiment described above, but various modifications may be made within the scope of the present invention defined by the appended claims.

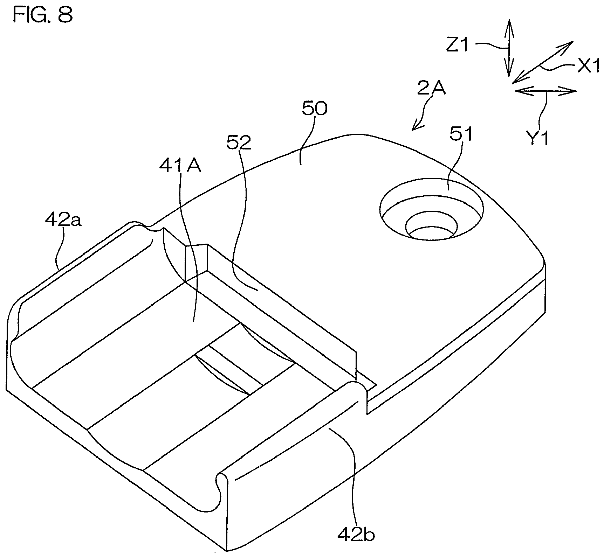

For example, brackets 2A each shown in FIG. 8 may be used instead of the brackets 2. In the following, differences from the embodiment described above will be mainly described. Like components will be designated by like reference characters, and duplicate description will be omitted.

The bracket 2A includes a base plate 41A, a pair of clamp pieces 42a, 42b disposed along transversely (Y1) opposite edges of the base plate 41A. The base plate 41A includes a fixture piece 50 provided longitudinally (X1) in tandem with the pair of clamp pieces 42a, 42b. The fixture piece 50 has an insertion hole 51 through which a fixture screw (not shown) is inserted. The base plate 41A has a step 52, which receives the cap 8 of the light emitting apparatus 1.

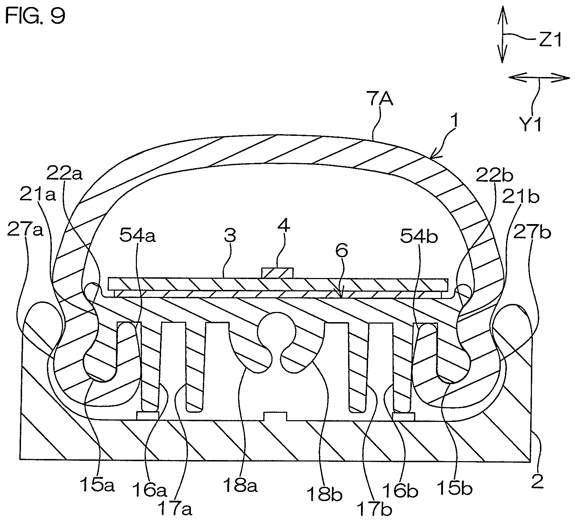

Further, a cover 7A shown in section in FIG. 9 may be used instead of the cover 7. The cover 7A differs from the cover 7 in that it includes no bottom wall 23 and has a generally semicircular shape as seen longitudinally (X1). A pair of claws 54a, 54b project from a pair of connection portions 27a, 27b of the cover 7A. One 54a of the claws is held between a first fin 15a and a second fin 16a. The other claw 54b is held between a first fin 15b and a second fin 16b.

With the arrangement described above, the pair of second fins 16a, 16b, a pair of third fins 17a, 17b and a pair of fourth fins 18a, 18b are disposed outside the cover 7A. Thus, the heat dissipation member 6 has a higher heat dissipation capability. The inside of the cover 7A is isolated from the outside by connection between the cover 7A and the heat dissipation member 6, whereby foreign matter such as dust is prevented from intruding into the cover 7A. Where the cover 7A is used, the connection strength between the cover 7A and the heat dissipation member 6 is sufficiently increased by the connection between the first projections 22a, 22b and the first recesses 21a, 21b. Therefore, smaller loads act on the claws 54a, 54b. Even with the provision of the thin claws 54a, 54b, the enclosure of the light emitting apparatus 1 has a sufficiently high strength.

In the above embodiments, the positions of the first projections 22a, 22b and the positions of the first recesses 21a, 21b may be exchanged. In this case, the first projections 22a, 22b are provided on the outer surfaces 6a, 6b of the heat dissipation member 6, and the first recesses 21a, 21b are provided on the inner surfaces 71a, 71b of the cover 7, 7A. The positions of the second projections 29a, 29b and the second recesses 28a, 28b may be exchanged. In this case, the second projections 29a, 29b are provided on the outer surfaces 72a, 72b of the cover 7, 7A, and the second recesses 28a, 28b are provided on the inner surfaces 46a, 46b of the brackets 2, 2A.

The LEDs 4 are used as the light emitting elements by way of example but not by way of limitation. Other types of light emitting elements such as fluorescent tubes may be used as the light emitting elements. Further, the heat dissipation member 6 may be formed by extrusion. Further, the first projections 22a, 22b may be each provided only on a part of the cover 7 defined longitudinally (X1). Similarly, the second projections 29a, 29b may be provided only on parts of the respective clamp pieces 42a, 42b defined longitudinally (X1).

While the present invention has thus been described in detail by way of specific embodiments thereof, those skilled in the art who understand the above disclosure will easily conceive alterations, modifications and equivalents of the embodiments. Therefore, the scope of the present invention should be construed as being defined by the claims and equivalents of the claims.

This application corresponds to Japanese Patent Application No. 2010-103718 filed in the Japan Patent Office on April 28, 2010, the disclosure of which is incorporated herein by reference in its entirety.

### REFERENCE SIGNS LIST

- 1: LIGHT EMITTING APPARATUS
- 2, 2a: BRACKETS
- 4: LEDS (LIGHT EMITTING ELEMENTS)
- 6: HEAT DISSIPATION MEMBER
- 6a, 6b: PAIR OF OUTER SURFACES
- 7, 7A: COVERS
- 14: BASE
- 15a, 15b, 16a, 16b, 17a, 17b, 18a, 18b: FINS
- 21a, 21b: FIRST RECESSES (RECESSES)
- 22a, 22b: FIRST PROJECTIONS (PROJECTIONS)
- 25a, 25b: PAIR OF SIDE WALLS
- 42a, 42b: PAIR OF CLAMP PIECES
- 46a, 46b: INNER SURFACES OF PAIR OF CLAMP PIECES
- 71a, 71b: INNER SURFACES OF PAIR OF SIDE WALLS
- X1: LONGITUDINAL DIRECTION

## Claims

1. A light emitting apparatus (1) comprising:
a light-transmissive cover (7) including a pair of side walls (25a, 25b);
a heat dissipation member (6) including a pair of outer surfaces (6a, 6b) disposed between inner surfaces (71 a, 71 b) of the pair of side walls (25a, 25b) of the cover (7) and including a fin (15-18) disposed between the outer surfaces (6a, 6b); and
a light emitting element (4) supported by the heat dissipation member (6) and accommodated in the cover (7);
one of the cover (7) and the heat dissipation member (6) having projections (22a, 22b) respectively provided on the inner surfaces (71 a, 71b) of the cover (7) or the outer surfaces (6a, 6b) of the heat dissipation member (6);
the other of the cover (7) and the heat dissipation member (6) having recesses (21a, 21b) respectively provided on the inner surfaces (71a, 71b) of the cover (7) or the outer surfaces (6a, 6b) of the heat dissipation member (6), the recesses (21a, 21b) extending longitudinally of the cover (7) in engagement with the respective projections (22a, 22b),
wherein the cover (7) has a hollow tubular shape to surround the heat dissipation member (6),
**characterized in that**
the fin (15-18) is covered with the cover (7).

2. The light emitting apparatus (1) according to claim 1, wherein the heat dissipation member (6) includes a base (14) which supports the light emitting element (4), and the light emitting element (4) is disposed on a side of the base (14) opposite from the fin (15-18).

3. The light emitting apparatus (1) according to claim 1 or 2, wherein the recesses (21 a, 21 b) and the projections (22a, 22b) each have a smoothly curved surface.

4. The light emitting apparatus (1) according to any ane of claims 1 to 3, wherein the recesses (21a, 21b) and the projections (22a, 22b) each extend longitudinally throughout the entire length of the corresponding one of the cover (7) and the heat dissipation member (6).

5. A light emitting apparatus mount structure comprising:
a light emitting apparatus (1) as recited in any one of claims 1 to 4; and
a bracket (2) to be fixed to a fixing surface;
wherein the bracket (2) includes a pair of clamp pieces (42a, 42b) which hold the pair of side walls (25a, 25b) of the cover (7) therebetween to hold the recesses (21 a, 21b) and the projections (22a, 22b) therebetween.

6. The light emitting apparatus mount structure according to claim 5, wherein the outer surfaces (72a, 72b) of the cover (7) are conformable to the inner surfaces (71 a, 71 b) of the cover as seen longitudinally of the cover (7).

7. The light emitting apparatus mount structure according to claim 5 or 6, wherein opposed inner surfaces (46a, 46b) of the pair of clamp pieces (42a, 42b) are curved to be fitted on the outer surfaces (72a, 72b) of the cover (7).

## Patentansprüche

1. Lichtemittierende Vorrichtung (1), mit:
einer lichtdurchlässigen Abdeckung (7), die Paar von Seitenwänden (25a, 25b) aufweist;
einem Wärmedissipationsglied (6), das ein Paar von äußeren Flächen (6a, 6b) aufweist, die zwischen inneren Flächen (71 a, 71 b) des Paares von Seitenwänden (25a, 25b) der Abdeckung (7) angeordnet sind und die eine Rippe (15-18) beinhalten, die zwischen den äußeren Flächen (6a, 6b) angeordnet ist; und
einem lichtemittierenden Element (4), das mittels des Wärmedissipationsgliedes (6) gelagert und in der Abdeckung (7) aufgenommen ist;
wobei die Abdeckung (7) oder das Wärmedissipationsglied (6) Vorsprünge (22a, 22b) aufweist, die an den inneren Flächen (71a, 71 b) der Abdeckung (7) bzw. an den äußeren Flächen (6a, 6b) des Wärmedissipationsgliedes (6) vorgesehen sind;
wobei das andere Element von Abdeckung (7) und Wärmedissipationsglied (6) Ausnehmungen (21a, 21 b) aufweist, die an den inneren Flächen (71 a, 71 b) der Abdeckung (7) bzw. an den äußeren Flächen (6a, 6b) des Wärmedissipationsgliedes (6) vorgesehen sind, wobei die Ausnehmungen (21a, 21b) sich, in Eingriff mit den jeweiligen Vorsprüngen (22a, 22b), in Längsrichtung der Abdeckung (7) erstrecken,
wobei die Abdeckung (7) eine hohle rohrförmige Gestalt aufweist, so dass sie das Wärmedissipationsglied (6) umgibt,
**dadurch gekennzeichnet, dass**
die Rippe (15-18) mit der Abdeckung (7) abgedeckt ist.

2. Lichtemittierende Vorrichtung (1) nach Anspruch 1, wobei das Wärmedissipationsglied (6) eine Basis (14) aufweist, die das lichtemittierende Element (4) lagert, und wobei das lichtemittierende Element (4) an einer Seite der Basis (14) angeordnet ist, welche Seite der Rippe (15-18) gegenüberliegt.

3. Lichtemittierende Vorrichtung (1) nach Anspruch 1 oder 2, wobei die Ausnehmungen (21a, 21b) und die Vorsprünge (22a, 22b) jeweils eine sanft gekrümmte Fläche aufweisen.

4. Lichtemittierende Vorrichtung (1) nach einem der Ansprüche 1 bis 3, wobei die Ausnehmungen (21a, 21 b) und die Vorsprünge (22a, 22b) sich jeweils über die gesamte Länge der Abdeckung (7) bzw. des Wärmedissipationsgliedes (6) in Längsrichtung erstrecken.

5. Halterstruktur für eine lichtemittierende Vorrichtung, mit:
einer lichtemittierenden Vorrichtung (1) nach einem der Ansprüche 1 bis 4; und
einer Klammer (2), die an einer Befestigungsfläche zu befestigen ist;
wobei die Klammer (2) ein Paar von Klemmstücken (42a, 42b) aufweist, die das Paar von Seitenwänden (25a, 25b) der Abdeckung (7) dazwischen halten, um die Ausnehmungen (21a, 21b) und die Vorsprünge (22a, 22b) dazwischen zu halten.

6. Halterstruktur für eine lichtemittierende Vorrichtung nach Anspruch 5, wobei die äußeren Flächen (72a, 72b) der Abdeckung (7) anpassbar sind an die inneren Flächen (71a, 71b) der Abdeckung, und zwar in Längsrichtung der Abdeckung (7) gesehen.

7. Halterstruktur für eine lichtemittierende Vorrichtung nach Anspruch 5 oder 6, wobei einander gegenüberliegende innere Flächen (46a, 46b) des Paares von Klemmstücken (42a, 42b) gekrümmt sind, so dass sie an die äußeren Flächen (72a, 72b) der Abdeckung (7) angepasst sind.

## Revendications

1. Appareil émetteur de lumière (1) comprenant :
un couvercle transmettant la lumière (7) comportant une paire de parois latérales (25a, 25b) ;
un élément dissipateur de chaleur (6) comportant une paire de surfaces extérieures (6a, 6b) disposées entre des surfaces intérieures (71a, 71b) de la paire de parois latérales (25a, 25b) du couvercle (7) et comportant une ailette (15-18) disposée entre les surfaces extérieures (6a, 6b) ; et
un élément émetteur de lumière (4) supporté par l'élément dissipateur de chaleur (6) et logé dans le couvercle (7) ;
un élément parmi le couvercle (7) et l'élément dissipateur de chaleur (6) ayant des saillies (22a, 22b) respectivement disposées sur les surfaces intérieures (71a, 71b) du couvercle (7) ou les surfaces extérieures (6a, 6b) de l'élément dissipateur de chaleur (6) ;
l'autre élément parmi le couvercle (7) et l'élément dissipateur de chaleur (6) ayant des encoches (21a, 21b) respectivement disposées sur les surfaces intérieures (71a, 71 b) du couvercle (7) ou les surfaces extérieures (6a, 6b) de l'élément dissipateur de chaleur (6), les encoches (21 a, 21 b) s'étendant longitudinalement par rapport au couvercle (7) en engagement avec les saillies respectives (22a, 22b),
dans lequel le couvercle (7) a une forme tubulaire creuse pour entourer l'élément dissipateur de chaleur (6),
**caractérisé en ce que** l'ailette (15-18) est recouverte par le couvercle (7).

2. Appareil émetteur de lumière (1) selon la revendication 1, dans lequel l'élément dissipateur de chaleur (6) comporte une base (14) qui supporte l'élément émetteur de lumière (4), et l'élément émetteur de lumière (4) est disposé sur un côté de la base (14) à l'opposé de l'ailette (15-18).

3. Appareil émetteur de lumière (1) selon la revendication 1 ou 2, dans lequel les encoches (21 a, 21 b) et les saillies (22a, 22b) ont chacune une surface de courbure uniforme.

4. Appareil émetteur de lumière (1) selon l'une quelconque des revendications 1 à 3, dans lequel les encoches (21a, 21 b) et les saillies (22a, 22b) s'étendent chacune longitudinalement sur la longueur entière de l'élément correspondant parmi le couvercle (7) et l'élément dissipateur de chaleur (6).

5. Structure de montage d'appareil émetteur de lumière comprenant :
un appareil émetteur de lumière (1) selon l'une quelconque des revendications 1 à 4 ; et
un support de fixation (2) devant être fixé à une surface de fixation ;
dans laquelle le support de fixation (2) comporte une paire de pièces de serrage (42a, 42b) qui maintiennent la paire de parois latérales (25a, 25b) du couvercle (7) entre celles-ci pour maintenir les encoches (21 a, 21b) et les saillies (22a, 22b) entre celles-ci.

6. Structure de montage d'appareil émetteur de lumière selon la revendication 5, dans laquelle les surfaces extérieures (72a, 72b) du couvercle (7) épousent les surfaces intérieures (71a, 71b) du couvercle dans une vue longitudinale du couvercle (7).

7. Structure de montage d'appareil émetteur de lumière selon la revendication 5 ou 6, dans laquelle des surfaces intérieures opposées (46a, 46b) de la paire de pièces de serrage (42a, 42b) sont incurvées pour être ajustées sur les surfaces extérieures (72a, 72b) du couvercle (7).
